(19) **Europäisches Patentamt**
**European Patent Office**
**Office européen des brevets**

(11) **EP 2 597 655 B1**

(12) **FASCICULE DE BREVET EUROPEEN**

(45) Date de publication et mention
de la délivrance du brevet:
**12.09.2018 Bulletin 2018/37**

(51) Int Cl.:
*H01F 10/32* *(2006.01)*          *H01F 41/30* *(2006.01)*

(21) Numéro de dépôt: **12193886.4**

(22) Date de dépôt: **22.11.2012**

(54) **Procédé de réalisation d'un dispositif comportant plusieurs blocs magnétiques aimantés selon des directions différentes**

Herstellungsverfahren einer Vorrichtung enthaltend mehrere magnetische Einheiten in verschiedene Richtungen magnetisiert

Manufacturing process for a device including several magnetic units magnetised along different directions

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **25.11.2011 FR 1160779**

(43) Date de publication de la demande:
**29.05.2013 Bulletin 2013/22**

(73) Titulaire: **Commissariat à l'Énergie Atomique et aux Énergies Alternatives**
**75015 Paris (FR)**

(72) Inventeur: **Delaet, Bertrand**
**38190 Bernin (FR)**

(74) Mandataire: **Colombo, Michel et al**
**Brevinnov**
**310 avenue Berthelot**
**69008 Lyon (FR)**

(56) Documents cités:
**EP-A1- 2 341 358**

- **ETTELT D ET AL: "A novel microfabricated high precision vector magnetometer", 2011 IEEE SENSORS IEEE PISCATAWAY, NJ, USA, 28 octobre 2011 (2011-10-28), pages 2010-2013, XP002674861, ISBN: 978-1-4244-9290-9**
- **ETTELT D ET AL: "A new low consumption 3D compass using integrated magnets and piezoresistive nano-gauges", TRANSDUCERS 2011 - 2011 16TH INTERNATIONAL SOLID-STATE SENSORS, ACTUATORS AND MICROSYSTEMS CONFERENCE IEEE PISCATAWAY, NJ, USA, 5 juin 2011 (2011-06-05), pages 40-43, XP002674862, ISBN: 978-1-4577-0157-3**

**Description**

L'invention concerne un procédé de réalisation d'un dispositif comportant plusieurs blocs magnétiques aimantés selon des directions différentes ainsi qu'un dispositif fabriqué selon ce procédé.

Dans ce texte par « aimantation » on désigne le moment magnétique du matériau magnétique.

Des procédés connus de réalisation d'un dispositif comportant plusieurs blocs magnétiques aimantés selon des directions différentes comportent :

a) la formation d'un premier bloc et d'un second bloc magnétique longilignes et disjoints sur un substrat s'étendant essentiellement dans un plan dit « plan du substrat », ces blocs s'étendant essentiellement le long, respectivement, de directions longitudinales X et Y réalisant entre elles un angle $\alpha$ non nul, la longueur L de chaque bloc le long de sa direction longitudinale étant au moins supérieure à vingt fois sa largueur W dans une direction transversale perpendiculaire à la direction longitudinale et parallèle au plan du substrat, chaque bloc étant formé d'un empilement de plusieurs couches ferromagnétique et antiferromagnétique disposées en alternance directement les unes sur les autres, chaque couche ferromagnétique étant réalisée dans un matériau magnétostrictif qui présente un coefficient $\lambda_s$ de magnétostriction dont la valeur absolue est supérieure à 20 ppm,

b) le recuit des premier et second blocs à une température supérieure à la température de mise en ordre ou à la température de blocage ou à la température de Néel de chaque couche antiferromagnétique de chaque bloc.

De plus, les procédés connus comportent :

- pendant l'étape de recuit, l'application d'un premier champ magnétique dont l'intensité est telle que :

  • cette intensité soit supérieure à un champ de saturation $H_{W1}$ selon l'axe de plus difficile aimantation du premier bloc, et
  • cette intensité soit supérieure à un champ de saturation $H_{W2}$ selon l'axe de plus difficile aimantation du second bloc, puis

- toujours pendant l'étape de recuit et après l'étape précédente, l'application d'un second champ magnétique dont l'intensité est telle que :

  • le module de la projection orthogonale du second champ magnétique le long de la direction longitudinale du premier bloc est supérieure à un champ de saturation $H_{L1}$ selon l'axe de plus facile aimantation de ce premier bloc,
  • le module de la projection orthogonale du second champ magnétique le long de la direction transversale du premier bloc est inférieur au champ de saturation $H_{W1}$,
  • le module de la projection orthogonale du second champ magnétique le long de la direction longitudinale du second bloc est supérieur à un champ de saturation $H_{L2}$ selon l'axe de plus facile aimantation de ce second bloc, et
  • le module de la projection orthogonale du second champ magnétique le long de la direction transversale du second bloc est inférieur au champ de saturation $H_{W2}$.

Par exemple, un tel procédé est divulgué dans la demande de brevet EP 2 341 358 déposée par le Commissariat à l'Energie Atomique et aux énergies alternatives.

De l'état de la technique est également connu de l'article de Ettelt D et AI, « A novel microfabricated high précision vector magnetometer », 2011 IEEE Sensors IEEE Piscataway, NJ, USA, 28 octobre 2011, pages 2010-2013.

L'invention vise à s'affranchir totalement ou partiellement du champ magnétique à appliquer ou, si on conserve ce champ, à améliorer l'alignement de la direction d'aimantation de chaque bloc magnétique sur sa direction longitudinale. Elle a donc pour objet d'un procédé conforme à la revendication 1.

Le dépôt d'une couche précontrainte sur chaque bloc magnétique permet d'aligner ou d'améliorer l'alignement de la direction d'aimantation sur la direction longitudinale lors du refroidissement. En effet, puisque la couche ferromagnétique est magnétostrictive, en exerçant une contrainte sur cette couche, il est possible de forcer l'aimantation de cette couche à s'aligner sur la direction longitudinale. Il n'est donc plus nécessaire d'appliquer un premier et un second champs magnétiques pendant le recuit ou, si ces champs sont utilisés, l'alignement de la direction d'aimantation de chaque bloc sur sa direction longitudinale est amélioré.

De plus, le dépôt d'une couche précontrainte permet de diminuer ou d'annuler l'hystérésis dans la réponse de ce bloc magnétique.

Les modes de réalisation de ce procédé peuvent comporter ou une plusieurs des caractéristiques des revendications dépendantes de procédé.

Ces modes de réalisation du procédé présentent en outre les avantages suivants :

- réaliser l'étape c) avant l'étape b) permet de réduire l'intensité du champ magnétique mis en oeuvre lors de l'étape e) car la couche précontrainte génère un champ magnétique d'anisotropie uniaxial $H_\sigma$ dans la direction longitudinale ;
- réaliser les étapes b) et c) en même temps permet d'accélérer le procédé de fabrication.

L'invention a également pour objet un procédé de fabrication d'un capteur magnétique lors duquel le procédé ci-dessus de réalisation d'un dispositif comportant plusieurs blocs magnétiques est mis en oeuvre.

Enfin, l'invention a pour objet un dispositif conforme à la revendication 10.

Les modes de réalisation de ce dispositif peuvent comporter la caractéristique de la revendication 11.

Le procédé et le dispositif peuvent aussi comporter les caractéristiques des revendications 12 et 13.

L'invention sera mieux comprise à la lecture de la description qui va suivre, donnée uniquement à titre d'exemple non limitatif et faite en se référant aux dessins sur lesquels :

- la figure 1 est un organigramme d'un procédé de fabrication d'un capteur tri-axe de champ magnétique dans lequel on réalise un dispositif comportant plusieurs blocs magnétiques aimantés dans des directions différentes,
- les figures 2, 3, 4 et 6 sont des illustrations schématiques de détails d'étapes de fabrication selon le procédé de la figure 1,
- la figure 5 est une illustration schématique et en vue de dessus de la contrainte mécanique exercée sur un bloc magnétique lors du procédé de la figure 1,
- la figure 7 est un graphe illustrant la réponse d'un bloc magnétique à une variation du champ magnétique extérieur selon sa direction longitudinale,
- la figure 8 est une illustration schématique d'un capteur tri-axe réalisé en utilisant le procédé de la figure 1,
- les figures 9 et 10 sont des graphes illustrant la variation de la contrainte mécanique dans une couche précontrainte en fonction de différents paramètres, et
- la figure 11 est un organigramme d'un autre mode de réalisation du procédé de la figure 1.

Dans ces figures, les mêmes références sont utilisées pour désigner les mêmes éléments.

Dans la suite de cette description, les caractéristiques et fonctions bien connues de l'homme de l'art ne sont pas décrites en détail.

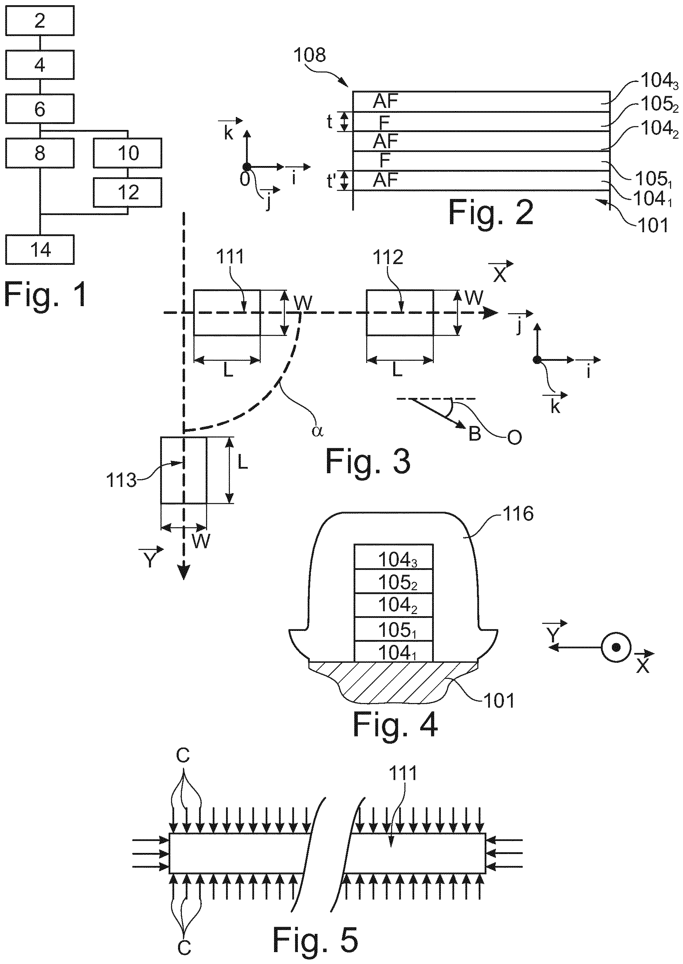

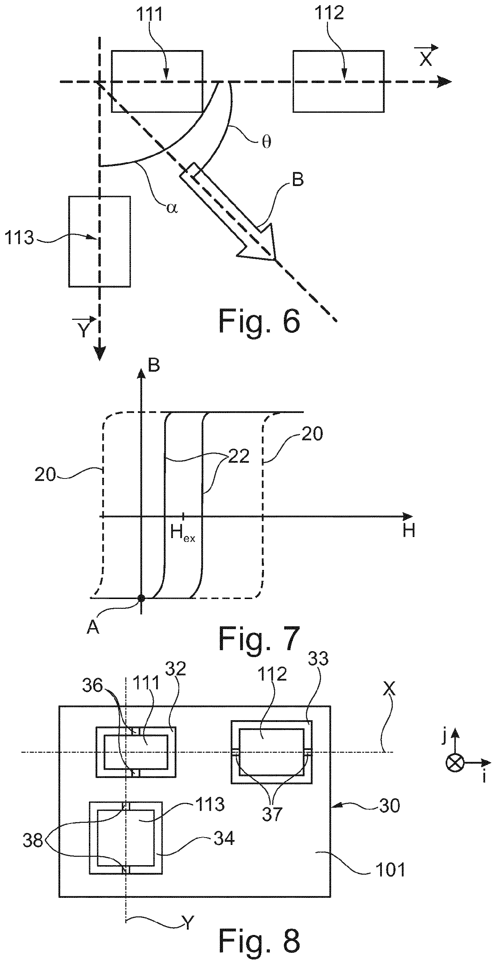

La figure 1 représente un exemple d'un procédé de fabrication du capteur tri-axe de la figure 8. Ce capteur tri-axe est réalisé comme décrit dans la demande de brevet EP2 341 358. Ainsi, seules les étapes nécessaires à la compréhension des différences par rapport au procédé connu sont représentées et décrites ici plus en détail. Plus précisément, seules les étapes pour la réalisation d'un dispositif comportant sur un même substrat trois blocs magnétiques dont deux ont des directions d'aimantation différentes sont représentées.

Le procédé débute par une étape 2 de réalisation d'un empilement 108 de couches magnétiques sur un support 101 (figure 2). Le support 101 est par exemple une couche de silicium d'un substrat SOI (« Silicon On Insulator »). Ici, il s'étend essentiellement dans un plan, appelé « plan du substrat », parallèle à des directions horizontales i et j d'un repère orthogonal i, j, k.

L'empilement 108 est formé d'une alternance de couches $104_1$, ... $104_n$ antiferromagnétiques et de couches $105_1$, ... $105_n$ ferromagnétiques. L'indice m est un entier positif représentant le nombre de couches antiferromagnétiques dans l'empilement 108. L'indice m est supérieur ou égal à un et, de préférence, supérieur ou égal à deux. Typiquement, il est compris entre deux et vingt-cinq. L'indice n représente le nombre de couches ferromagnétiques dans l'empilement 108. Cet indice n est supérieur à un et, de préférence, compris entre un et vingt-quatre. Un mode de réalisation préféré de l'empilement 108 est le cas où celui-ci comporte uniquement une couche ferromagnétique 105 interposée entre deux couches antiferromagnétiques 104. Le mode de réalisation le plus simple est celui où l'empilement 108 comporte uniquement une couche ferromagnétique déposée sur une seule couche antiferromagnétique.

Dans l'empilement 108, chaque couche ferromagnétique est directement déposée sur une couche antiferromagnétique inférieure. De préférence, chaque couche ferromagnétique 105 comporte une face inférieure directement en contact avec la couche antiferromagnétique inférieure et une face supérieure directement en contact avec la couche antiferromagnétique supérieure. L'empilement 108 ne comporte aucune couche intermédiaire interposée entre une couche ferromagnétique 105 et une couche antiferromagnétique 104 apte à empêcher le couplage magnétique entre les couches 104 et 105. Ainsi, la direction d'aimantation de chaque couche ferromagnétique 105 est piégée par la ou les couches antiferromagnétiques directement en contact avec cette couche 105.

Les couches ferromagnétiques sont réalisées dans un matériau magnétique doux ayant une forte aimantation à saturation $M_s$. Typiquement, par forte aimantation à saturation, on désigne une aimantation à saturation typiquement supérieure à 1000 emu/cm$^3$ (1 emu/cm$^3$ est égal à $10^3$ A/m) mesurée dans un cube de matière d'au moins 1cm de côté à 25°C.

Chaque couche ferromagnétique est réalisée dans un matériau magnétostrictif. De préférence, ce matériau est le même pour chaque couche. Ici, ce sont les propriétés magnétostrictives inverses, également connues sous l'expression anglaise de « Villari effect » qui sont exploitées. Les propriétés magnétostrictives inverses consistent à modifier les propriétés magnétiques d'un matériau en réponse à une contrainte mécanique exercée sur ce matériau. Typiquement, l'application d'une contrainte uniaxiale $\sigma$ sur un matériau magnétostrictif produit un champ magnétique d'anisotropie uniaxial appelé $H_k$ ou $H_\sigma$. L'intensité de ce champ $H_\sigma$ est donnée par la relation suivante : $H_\sigma = 3\lambda_s\sigma/M_s$, où :

- $\lambda_s$ est le coefficient de magnétostriction du matériau exprimé en ppm (partie par million ou $10^{-6}$), et
- $M_s$ est l'aimantation du matériau à saturation.

Le coefficient $\lambda_s$ de magnétostriction est une grandeur standard en magnétisme qui traduit l'allongement relatif (en ppm ou %) lorsque le matériau est saturé par l'application d'un champ magnétique. Les techniques de mesure sont standardisées. Par exemple, il peut s'agir d'une méthode directe telle que la déflexion d'un bilame avec l'application d'un champ magnétique et détection optique de la flexion (voir par exemple l'équipementier de bancs de mesure Lafouda® US) ou d'une méthode indirecte telle que la mesure du cycle d'hystérésis en appliquant une contrainte (voir par exemple l'équipementier BH Looper® SHB US).

Chaque couche ferromagnétique présente un coefficient $\lambda_s$ dont la valeur absolue est supérieure à dix, vingt ou quarante ppm. De préférence, le coefficient $\lambda_s$ des couches ferromagnétiques est supérieur à 50 ou 100 ppm. Ici, on suppose que chaque couche ferromagnétique présente des propriétés magnétostrictives positives et donc un coefficient $\lambda_s$ positif.

Le matériau ferromagnétique utilisé pour réaliser les couches ferromagnétiques est, par exemple, un alliage à base de fer ou de cobalt ou de nickel tel que les alliages CoFe ou CoFeB. La valeur du coefficient $\lambda_s$ varie en fonction de la proportion de Cobalt et de Fer dans les alliages CoFe. Ainsi, ici, seuls les alliages CoFe présentant un coefficient $\lambda_s$ dont la valeur est supérieure à 20 ou 50 ppm sont utilisés. Les alliages de CoFeB peuvent présenter des coefficients $\lambda_s$ supérieurs à ceux atteignables avec des alliages CoFe. Ainsi, ils sont généralement préférés pour la réalisation des couches ferromagnétiques.

Les couches antiferromagnétiques sont par exemple réalisées dans un alliage à base de manganèse tel que le NiMn, le PtMn, le FeMn ou le IrMn. La couche antiferromagnétique peut également être réalisée dans un alliage, par exemple, de NiO.

L'épaisseur des couches antiferromagnétiques t' est typiquement comprise entre 2 et 50nm. Par exemple, ici, elle est égale à 20nm. L'épaisseur des couches ferromagnétiques t est typiquement comprise entre 2 et 40nm. Par exemple ici, l'épaisseur t est égale à 10nm. De préférence, les épaisseurs t' et t sont les mêmes pour toutes les couches, respectivement, 104 et 105 de l'empilement 108. L'épaisseur de chaque couche est mesurée le long de la direction verticale k du repère orthogonal i, j, k.

L'épaisseur totale de l'empilement 108 est par exemple comprise entre 200 et 600nm.

Ensuite, lors d'une étape 4, trois blocs 111, 112 et 113 (Figure 3) distincts et disjoints sont formés en découpant l'empilement 108. Typiquement, ces blocs 111, 112 et 113 sont formés par gravure des couches de l'empilement 108 par exemple à l'aide d'une gravure IBE (« Ion Beam Etching »).

Chaque bloc 111 à 113 a une forme allongée ou longiligne. Par exemple, chaque bloc 111 à 113 présente la forme d'un parallélépipède rectangle.

Chaque bloc 111 à 113 s'étend essentiellement le long d'une direction longitudinale. La direction longitudinale le long de laquelle s'étendent les blocs 111 et 112 est notée X. La direction X est ici parallèle à la direction i. Le bloc 113 s'étend le long d'une direction longitudinale Y parallèle à la direction j. Les directions X et Y forment donc un angle $\alpha$ égal à 90°. Dans ce mode de réalisation particulier, les blocs 111, 112 et 113 ont des dimensions identiques. La longueur de chacun de ces blocs le long de leurs directions longitudinales est notée L. La largeur de ces blocs 111 à 113 dans leurs directions transversales est notée W. La direction transversale est la direction horizontale perpendiculaire à la direction longitudinale de chacun de ces blocs.

Pour chacun de ces blocs, la longueur L est au moins vingt fois et, de préférence au moins quarante ou cent fois supérieure à la largeur W. Ainsi, chacun de ces blocs présente un rapport de forme important, ici supérieur à vingt, quarante ou cent. Dans ces conditions, la direction de plus facile aimantation de chacun de ces blocs est parallèle à sa direction longitudinale. A l'inverse, sa direction de plus difficile aimantation est parallèle à la direction transversale de chacun de ces blocs.

Par exemple, la largeur W est comprise entre $0.1\mu m$ et $30\mu m$ ou $40\mu m$ et, de préférence, comprise entre 5 et $15\mu m$. La longueur L est typiquement supérieure à $40\mu m$ ou $100\mu m$ et, de préférence, inférieure à $500\mu m$ ou 1mm.

Ensuite, lors d'une étape 6, une couche précontrainte 116 (figure 4) est déposée directement sur chaque bloc 111 à 113. Par exemple, cette couche 116 recouvre toute la face supérieure du substrat 101. Cette couche 116 crée dans chacun de ces blocs 111 à 113 une contrainte mécanique uniaxiale $\sigma$ en tension parallèlement à la direction longitudinale de chacun de ces blocs. Autrement dit, cette couche 116 tend à étirer chaque couche ferromagnétique de chacun des blocs dans sa direction longitudinale.

On notera ici qu'une contrainte uniaxiale en tension dans la direction longitudinale est équivalente à exercer une contrainte en compression dans la direction transversale du même bloc.

Dans ce mode de réalisation, la couche 116 exerce une contrainte en compression uniforme sur l'ensemble des faces verticales de chacun des blocs 111 à 113. A cet effet, la couche 116 recouvre la totalité des faces verticales de chacun des blocs. Ici, la couche 116 recouvre également la totalité de la face supérieure horizontale de chacun des blocs. Ainsi, la couche 116 entoure uniformément chacune des couches ferromagnétiques de chaque bloc.

L'épaisseur de la couche 116 est supérieure à l'épaisseur de l'empilement 108 dans la direction verticale. Pour simplifier la figure 3, les rapports d'épaisseur entre les couches n'ont pas été respectés.

Ici, la couche 116 exerce une contrainte compressive uniforme $\sigma$ sur chaque bloc 111 à 113 d'au moins 10 MPa et, de préférence, d'au moins 30 ou 40 MPa.

La contrainte exercée par la couche 116 est ajustée en jouant, par exemple, sur les conditions de dépôt de cette couche 116. Ici, la contrainte $\sigma$ est ajustée pour que le produit $\lambda_s\sigma$ soit supérieur à 300 ppm.MPa et, de préférence, supérieur à 500 ppm.MPa ou 1.000 ppm.MPa. De façon encore plus préférée, la contrainte $\sigma$ est ajusté pour que le produit $\lambda_s\sigma$ soit supérieur à 5000 ppm.MPa et, avantageusement, à 10000 ou 50000 ppm.MPa. Les conditions de dépôt sur lesquelles il faut jouer dépendent du matériau choisi pour réaliser la couche 116. En effet, il peut s'agir de la température de dépôt, de la proportion de précurseur, de la vitesse de dépôt ou autres.

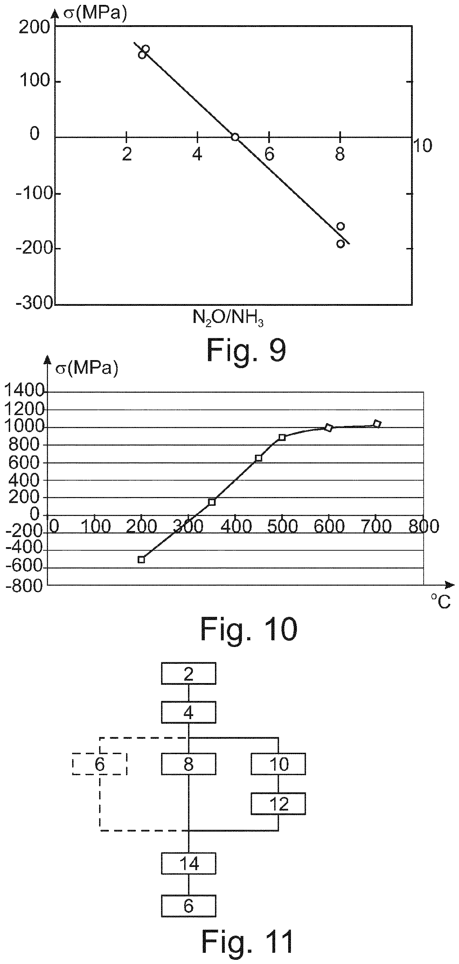

Par exemple, la couche 116 est réalisée dans un matériau électriquement isolant tel qu'un oxyde ou un nitrure. Ainsi, la couche 116 peut être réalisée en $SiH_4$, $SiO_2$, TEOS ($Si(OC_2H_5)_4$), SiN, SiON, $Si_3N_4$,..., etc. Dans le cas du SiON, la contrainte $\sigma$ est ajusté en jouant sur le ratio entre les débits de gaz $N_2O$ et $NH_3$ comme montré sur le graphe de la figure 9. L'abscisse de ce graphe représente le ratio des débits de gaz $N_2O$ et de gaz $NH_3$. L'ordonnée représente la contrainte $\sigma$ exprimée en MPa.

La couche 116 peut aussi être réalisée en métal non magnétique tel que du W2N, Ru, Pt ou autres. Dans ce cas, la contrainte $\sigma$ peut être ajusté en fonction d'une température de recuit comme illustré sur le graphe de la figure 10 dans le cas particulier du platine. Sur le graphe de la figure 10, les abscisses représentent la température de recuit utilisée tandis que les ordonnées représentent la valeur de la contrainte $\sigma$ exprimée en MPa. La demande de brevet WO 2011/001293 décrit aussi des méthodes pour ajuster la contrainte $\sigma$ dans une couche précontrainte.

Lorsque la couche 116 est réalisée en métal, la valeur de la contrainte $\sigma$ peut être ajustée après les dépôts de l'empilement 108 et de la couche 116. A l'inverse, lorsque la couche 116 est un isolant, l'ajustement de la valeur de la contrainte $\sigma$ est réalisé directement lors du dépôt de la couche 116. L'utilisation d'un isolant pour réaliser la couche 116 présente l'avantage qu'une fois la contrainte ajustée au moment du dépôt ou d'un recuit suivant directement son dépôt, les contraintes dans l'empilement n'évoluent plus avec la température. Ainsi, il est possible de réaliser des recuits, par exemple pour le packaging du bloc, à plus haute température sans risque d'évolution des contraintes dans l'empilement et donc d'endommagement pour le bloc.

La figure 5 permet de comprendre comment une contrainte $\sigma$ uniformément répartie sur un bloc permet d'exercer une contrainte uniaxiale dans ce bloc. Sur la figure 5, le bloc 111 est représenté en vue de dessus. Les flèches C uniformément réparties sur le pourtour du bloc représentent la contrainte $\sigma$ exercée sur son pourtour.

Etant donné que le bloc 111 est beaucoup plus long que large, les faces verticales parallèles à la direction longitudinale sont soumises à une force beaucoup plus importante que les faces verticales d'extrémité parallèles à la direction transversale. Ainsi, la contrainte en compression exercée dans la direction longitudinale est négligeable devant la contrainte en compression exercée dans la direction transversale. Cette contrainte en compression dans la direction transversale est équivalente à une contrainte en tension dans la direction longitudinale. Ainsi, une contrainte uniaxiale en tension apparaît dans l'empilement 108 car la contrainte en compression dans la direction longitudinale est négligeable. A contrario, le même agencement appliqué à un empilement ne présentant pas de facteur de forme important ne permet pas la création d'une contrainte uniaxiale.

Ensuite, lors d'une étape 8, un recuit de mise en ordre magnétique est réalisé. Lors de ce recuit, la température atteinte est choisie de manière à réaliser une mise en ordre du matériau antiferromagnétique.

Lorsque les couches antiferromagnétiques sont en matériau non ordonné, par exemple du type NiMn ou PtMn, c'est-à-dire un matériau qui ne présente pas de couplage d'échange après dépôt, l'étape de recuit est effectuée à une température supérieure ou égale à la température de mise en ordre de ce matériau. Cette température de mise en ordre est typiquement supérieure à 250°C. Lorsque la couche antiferromagnétique est réalisée dans un matériau antiferromagnétique ordonné tel que du FeMn ou du IrMn ou du NiO, c'est-à-dire d'un matériau qui présente un couplage d'échange avec la couche ferromagnétique après son dépôt, l'étape de recuit est effectuée au-dessus de la température de blocage ou de la température de Néel de ce matériau soit typiquement à une température supérieure à 150°C ou 250°C.

Par exemple, ici, le recuit est effectué à une température supérieure à 260°C lorsque la couche antiferromagnétique est en PtMn. Dans ces conditions, la direction d'aimantation des couches ferromagnétiques n'est pas figée par les couches antiferromagnétiques.

L'effet de forme des barreaux est dominant et l'aimantation s'aligne dans la direction longitudinale de chaque bloc et se piège pendant le refroidissement.

Dans ce mode de réalisation, en complément, un champ magnétique est appliqué pendant le recuit.

Dans ce cas, en parallèle de l'étape 8, lors d'une étape 10, un premier champ magnétique $B_1$ est appliqué. Ce champ magnétique $B_1$ est orienté de manière à réaliser un angle non nul avec les directions longitudinales X et Y. Par exemple, le champ magnétique $B_1$ est parallèle au plan du substrat et réalise un angle $\theta$ non nul avec la direction X (Figure 6). Typiquement, l'angle $\theta$ est égal à la moitié de l'angle a. Ainsi, dans ce mode de réalisation, l'angle $\theta$ est égal à 45° à plus ou moins 10 % près.

Lors de l'étape 10, l'intensité du champ magnétique $B_1$ est supérieure au champ de saturation $H_W$ de chacun des blocs 111 à 113 le long de leur axe de plus difficile aimantation. Dans ces conditions, le champ $B_1$ permet de saturer l'aimantation de chaque couche ferromagnétique et donc d'éliminer tous les domaines magnétiques de chacune des couches ferromagnétiques.

Pour arriver à ce résultat, l'intensité du champ magnétique $B_1$ (ou son module) est telle qu'elle satisfait les deux conditions suivantes :

1) elle est supérieure au champ de saturation $H_W$ des blocs 111 et 112, et
2) elle est supérieure au champ de saturation $H_W$ du bloc 113.

L'intensité du champ magnétique $B_1$ lors de l'étape 10 peut être très supérieure aux valeurs inférieures définies par les conditions 1) et 2) ci-dessus. Par exemple, l'intensité du champ magnétique $B_1$ est de l'ordre de 1 à 2 T.

Il est possible ensuite de maintenir ou non un champ magnétique. Ici, un champ magnétique est maintenu.

Ainsi, ensuite, toujours en parallèle de l'étape 8, lors d'une étape 12, le champ magnétique $B_1$ est remplacé par un champ magnétique $B_2$. Par exemple, le champ $B_2$ est identique au champ $B_1$ sauf que son intensité est réduite. Plus précisément, lors de l'étape 12, l'intensité du champ magnétique $B_2$ est ajustée pour que celle-ci satisfasse les quatre conditions suivantes :

1) le module de la projection orthogonale du champ magnétique $B_2$ sur la direction X est supérieur au champ de saturation $H_L$ selon l'axe de plus facile aimantation des blocs 111 et 112,
2) le module de la projection orthogonale du champ magnétique $B_2$ sur la direction Y est strictement inférieur au champ de saturation $H_W$ des blocs 111 et 112,
3) le module de la projection orthogonale du champ magnétique $B_2$ sur la direction Y est supérieur au champ de saturation $H_L$ du bloc 113, et
4) le module de la projection orthogonale du champ magnétique $B_2$ sur la direction X est inférieur au champ de saturation $H_W$ du bloc 113.

Dans ces conditions, le champ magnétique B2 facilite et améliore l'alignement de la direction d'aimantation des couches ferromagnétiques des blocs 111 et 112 le long de la direction X et de la direction d'aimantation du bloc 113 le long de la direction Y en complément du facteur de forme.

L'alignement de la direction d'aimantation des couches ferromagnétiques d'un bloc sur sa direction longitudinale est d'autant plus précis que le module de la projection orthogonale du champ magnétique $B_2$ sur sa direction transversale est petit. Pour cela, l'intensité du champ $B_2$ est typiquement choisie pour que le module de la projection du champ magnétique $B_2$ le long de la direction transversale soit au moins vingt fois et, de préférence cinquante fois, inférieur au champ $H_W$ de ce bloc. Cela conduit également à une faible valeur du module de la projection du champ $B_2$ sur la direction longitudinale. Toutefois, dans ce mode de réalisation, la couche précontrainte 116 permet d'améliorer l'alignement de la direction d'aimantation de chaque bloc le long de sa direction longitudinale et cela en utilisant une intensité réduite du champ magnétique $B_2$. En effet, la couche précontrainte entraîne l'apparition d'un champ magnétique d'anisotropie uniaxial $H_\sigma$ le long de la direction longitudinale qui vient se cumuler avec l'intensité du champ magnétique $B_2$ dans cette direction longitudinale. Ainsi, par rapport au procédé précédemment connu, l'intensité du champ magnétique $B_2$ peut être réduite à performance égale ou on peut obtenir un meilleur alignement en utilisant le même champ $B_2$ que dans les procédés connus.

On rappelle ici que les champs de saturation $H_L$ et $H_W$ d'un bloc parallélépipédique peuvent être évalués à l'aide des formules suivantes :

$$H_L = \frac{Wt}{L^2}\left[\ln\left(\frac{4L}{W}\right) - 1\right] * 4 * \pi * Ms$$

$$Hw = 4 * \pi * Ms * t * \left[ \frac{1}{t+W} - \frac{W}{L^2} \left[ \ln\left(\frac{4L}{W}\right) - 1 \right] \right]$$

où :

- t est l'épaisseur cumulé des couches ferromagnétiques de l'empilement 108,
- $M_s$ est l'aimantation à saturation,
- L est la longueur du bloc, et
- W est la largeur du bloc.

Enfin, lors d'une étape 14 de refroidissement, la température de recuit est réduite progressivement et retombe en dessous de la température de blocage ou de la température de mise en ordre ou de la température de Néel des couches antiferromagnétiques. Les couches antiferromagnétiques viennent alors piéger la direction d'aimantation dans les couches ferromagnétiques, ce qui permet donc de figer définitivement cette direction d'aimantation. Lors de l'étape 14, le champ $B_2$ peut être maintenu.

Ainsi, à l'issue de l'étape 14, on obtient des blocs 111 et 112 ayant une direction d'aimantation parallèle à la direction X et un bloc 113 dont la direction d'aimantation est parallèle à la direction Y à quelques degrés près.

L'utilisation de la couche précontrainte 116 permet non seulement d'améliorer l'alignement de la direction d'aimantation de chaque bloc sur sa direction longitudinale ou de s'affranchir du champ extérieur mais permet également de diminuer l'hystérésis des blocs magnétiques comme représenté sur le graphe de la figure 7. Sur ce graphe, la courbe 20 représente le cycle d'hystérésis de l'aimantation d'un bloc magnétique identique au bloc magnétique 111 sauf qu'il est dépourvu de couche précontrainte. Le cycle représenté sur la figure 7 est classiquement centré autour du champ d'échange $H_{ex}$. Sur ce même graphe, la courbe 22 représente le cycle d'aimantation du bloc 111. La présence de la couche précontrainte permet de diminuer l'hystérésis autour du champ d'échange $H_{ex}$ et ainsi de décaler l'intégralité du cycle autour de ce champ d'échange pour n'avoir plus qu'un seul état d'aimantation en champ nul correspondant au point A sur la courbe 22.

La figure 8 représente un capteur tri-axe 30 de champ magnétique. Ce capteur 30 comporte le substrat 101 ainsi que les trois blocs magnétiques 111 à 113 fabriqués selon le procédé de la figure 1. Les blocs 111 à 113 sont chacun placés dans une cavité, respectivement, 32 à 34 et fixés aux parois de cette cavité de manière à pouvoir se déplacer en rotation, respectivement, autour des directions j, k et k. L'angle de rotation de chacun des blocs magnétiques autour de son axe de rotation est mesuré par des jauges de contrainte, respectivement, 36 à 38.

Un tel capteur est par exemple décrit plus en détail dans l'article suivant :

B. Ettelt et al, « A new low consumption 3D compass using integrated magnets and piezoresistive nano-gauges », Transducers 2011 Conférence, Beijing, Chine.

Ainsi, ce capteur 30 n'est pas décrit ici plus en détail.

De nombreux autres modes de réalisation sont possibles. Par exemple, la figure 11 représente un organigramme d'un autre procédé de réalisation des blocs magnétiques 111 à 113. Le procédé de la figure 11 est identique au procédé de la figure 1 sauf que l'étape 6 a été déplacée après l'étape 14.

L'étape 6 peut aussi être réalisée en parallèle de l'étape 8 comme représenté en pointillé sur la figure 11. Par exemple, le dépôt de la couche 116 est réalisé à une température supérieure à la température de mise en ordre ou à la température de blocage ou à la température de Néel des couches antiferromagnétiques.

En variante, les étapes 10 et 12 sont omises. Dans ce cas, c'est l'effet de forme des barreaux qui domine et pousse l'aimantation à s'aligner dans la direction longitudinale du bloc. Cet alignement de la direction d'aimantation est alors piégé lors du refroidissement. Il est aussi possible de mettre en oeuvre uniquement l'étape 10 sans mettre en oeuvre l'étape 12 et vice versa. Dans une autre variante, l'étape 12 est uniquement mise en oeuvre pendant le l'étape 14 de refroidissement et non pas pendant l'étape 8 de recuit.

Les couches ferromagnétiques peuvent être réalisées dans un matériau magnétique présentant des propriétés magnétostrictives négatives, ce qui correspond à un coefficient $\lambda_s$ strictement inférieur à zéro. Par exemple, la couche ferromagnétique est en cobalt. Dans ce cas, la couche précontrainte est conçue pour générer une contrainte uniaxiale $\sigma$ compressive dans la direction longitudinale et non plus, comme précédemment, dans la direction transversale. La valeur de la contrainte $\sigma$ est alors négative. La couche précontrainte est donc par exemple agencée pour exercer une contrainte $\sigma$ négative, et non plus positive, sur les faces latérales du bloc parallèles à la direction longitudinale.

En variante, la couche précontrainte recouvre uniquement la partie des faces latérales du bloc en vis-à-vis ou en contact direct avec les faces verticales des couches ferromagnétiques. Ainsi, il n'est pas nécessaire que la couche précontrainte 116 recouvre la face supérieure ou inférieure du bloc ou que la couche 116 recouvre la totalité des faces verticales de ce bloc.

A l'inverse, la couche 116 peut recouvrir uniquement la face horizontale supérieure ou inférieure du bloc magnétique sans recouvrir les faces verticales de ce bloc. Dans ce cas, la distance d̲ maximale qui sépare la couche précontrainte de la face horizontale de la couche ferromagnétique la plus éloignée est inférieure à l'épaisseur de la couche précontrainte et, de préférence, inférieure à dix ou cent fois l'épaisseur de la couche précontrainte.

La couche précontrainte peut ne recouvrir que les faces longitudinales parallèles à la direction longitudinale sans recouvrir les faces perpendiculaires à cette direction. De préférence, lorsque la couche précontrainte recouvre une face longitudinale, elle s'étant continument d'une extrémité à l'autre de cette face dans la direction longitunale.

Dans le cas où la couche précontrainte entoure le bloc magnétique, cette couche précontrainte n'a pas besoin d'être directement en contact avec les couches ferromagnétiques pour exercer la contrainte $\sigma$ sur ces couches ferromagnétiques. Par exemple, une couche intermédiaire non précontrainte sépare la couche précontrainte des couches ferromagnétiques. Dans ce cas, la distance entre la couche précontrainte et les couches ferromagnétiques n'a pas besoin d'être inférieure à la distance d précédemment décrite.

Le bloc magnétique peut être formé de plusieurs brins rectilignes et parallèles entre eux dont les extrémités sont recourbées pour rejoindre l'extrémité d'un brin immédiatement adjacent dans la direction transversale. Dans ce cas, chaque brin a un facteur de forme supérieur à vingt, quarante ou cent.

En variante, comme décrit en détail dans la demande EP 2 341 358, chaque bloc est sous la forme d'un ensemble de sous-blocs parallélépipédiques rectangles parallèles et disjoints entre eux.

Dans une autre variante, les blocs peuvent avoir des dimensions différentes les uns des autres. Dans ce cas, les champs de saturation $H_W$ et $H_L$ ne sont pas les mêmes d'un bloc à l'autre.

Les directions X et Y ne sont pas nécessairement orthogonales. Par exemple, il peut être intéressant de disposer trois blocs à 120° les uns des autres et ainsi obtenir trois orientations différentes. Dans le cas où les directions X et Y ne sont pas orthogonales et forment un angle non nul $\alpha$ différent de 90°, l'angle $\theta$ du champ magnétique appliqué lors des étapes 10 et 12 est typiquement pris égal à la moitié de l'angle $\alpha$.

En variante, les directions des champs $B_1$ et $B_2$ appliqués lors des étapes 10 et 12 peuvent être différentes.

## Revendications

1. Procédé de réalisation d'un dispositif comportant plusieurs blocs magnétiques aimantés selon des directions différentes, ce procédé comportant :

   a) la formation (2, 4) d'un premier bloc et d'un second bloc magnétique longilignes et disjoints sur un substrat s'étendant essentiellement dans un plan dit « plan du substrat », ces blocs s'étendant essentiellement le long, respectivement, de directions longitudinales X et Y réalisant entre elles un angle $\alpha$ non nul, la longueur L de chaque bloc le long de sa direction longitudinale étant au moins supérieure à vingt fois sa larguer W dans une direction transversale perpendiculaire à la direction longitudinale et parallèle au plan du substrat, chaque bloc étant formé d'un empilement de plusieurs couches ferromagnétique et antiferromagnétique disposées en alternance directement les unes sur les autres, chaque couche ferromagnétique étant réalisée dans un matériau magnétostrictif qui présente un coefficient $\lambda_s$ de magnétostriction dont la valeur absolue est supérieure à 20 ppm,
   b) le recuit (8) des premier et second blocs à une température supérieure à la température de mise en ordre ou à la température de blocage ou à la température de Néel de chaque couche antiferromagnétique de chaque bloc,

   **caractérisé en ce que** procédé comporte :

   c) le dépôt (6) d'une couche précontrainte exerçant une contrainte uniaxiale $\sigma$ dans la direction longitudinale de chaque bloc magnétique telle que $\lambda_s\sigma$ est positif et supérieur ou égal à 1000 ppm.MPa de manière à améliorer l'alignement de la direction d'aimantation de chaque couche ferromagnétique sur la direction longitudinale.

2. Procédé selon la revendication 1, dans lequel le procédé comporte :

   d) pendant l'étape de recuit, l'application (10) d'un premier champ magnétique dans une direction réalisant un angle $\theta$ non nul avec les directions longitudinales X et Y, l'intensité de ce premier champ magnétique étant:

      • supérieure à un champ de saturation $H_{W1}$ selon l'axe de plus difficile aimantation de ce premier bloc, et
      • supérieure à un champ de saturation $H_{W2}$ selon l'axe de plus difficile aimantation de ce second bloc.

3. Procédé selon la revendication 2, dans lequel le procédé comporte :

e) après l'étape d), l'application (12) d'un second champ magnétique dont l'intensité est telle que :

- le module de la projection orthogonale du second champ magnétique le long de la direction longitudinale du premier bloc est supérieur à un champ de saturation $H_{L1}$ selon l'axe de plus facile aimantation de ce premier bloc,
- le module de la projection orthogonale du second champ magnétique le long de la direction transversale du premier bloc est inférieur au champ de saturation $H_{W1}$ selon l'axe de plus difficile aimantation de ce premier bloc,
- le module de la projection orthogonale du second champ magnétique le long de la direction longitudinale du second bloc est supérieur à un champ de saturation $H_{L2}$ selon l'axe de plus facile aimantation de ce second bloc, et
- le module de la projection orthogonale du second champ magnétique le long de la direction transversale du second bloc est inférieur au champ de saturation $H_{W2}$ selon l'axe de plus difficile aimantation de ce second bloc.

4. Procédé selon la revendication 3, dans lequel l'étape e) est réalisée tout en laissant refroidir chaque bloc en dessous de la température de mise en ordre ou de la température de blocage ou de la température de Néel de chaque couche antiferromagnétique.

5. Procédé selon l'une quelconque des revendications 3 à 4, dans lequel l'angle entre les directions longitudinales des premier et second blocs est égal à 90° et le champ magnétique appliqué lors de l'étape e) fait un angle de 45° avec la direction longitudinale du premier bloc.

6. Procédé selon l'une quelconque des revendications 3 à 5, dans lequel l'étape c) est réalisée après la fin de l'étape e).

7. Procédé selon l'une quelconque des revendications 1 à 5, dans lequel l'étape c) est réalisée avant l'étape b) ou en même temps que l'étape b).

8. Procédé selon la revendication 7, dans lequel les étapes b) et c) sont réalisées en même temps de sorte que l'étape c) est réalisée à une température supérieure à la température de mise en ordre ou à la température de blocage ou à la température de Néel de chaque couche antiferromagnétique.

9. Procédé de fabrication d'un capteur magnétique, **caractérisé en ce qu'**il comprend la mise en oeuvre d'un procédé selon l'une quelconque des revendications précédentes pour réaliser au moins deux blocs magnétiques ayant des directions de piégeage de l'aimantation différentes dans le même plan.

10. Dispositif comportant :

- un substrat (101) s'étendant essentiellement parallèlement à un plan dit « plan du substrat »,
- au moins deux blocs magnétiques aimantés (111-113) selon des directions différentes parallèles au plan du substrat, la longueur de chacun de ces blocs magnétiques dans sa direction longitudinale étant au moins vingt fois supérieure à sa largeur dans une direction transversale perpendiculaire à la direction longitudinale et parallèle au plan du substrat, chaque bloc étant formé d'un empilement de plusieurs couches ferromagnétique et antiferromagnétique déposées en alternance directement les unes sur les autres,

**caractérisé en ce que** :

- chaque couche ferromagnétique (105) est réalisée dans un matériau magnétostrictif qui présente un coefficient $\lambda_s$ de magnétostriction dont la valeur absolue est supérieure à 20 ppm, et
- le dispositif comporte une couche précontrainte (116) exerçant une contrainte uniaxiale $\sigma$ sur chaque bloc magnétique tel que $\lambda_s\sigma$ est positif et supérieur ou égal à 1000 ppm.MPa de manière à améliorer l'alignement de la direction d'aimantation de chaque couche ferromagnétique sur la direction longitudinale.

11. Dispositif selon la revendication 10, dans lequel la couche précontrainte est en oxyde ou en nitrure ou en métal.

12. Procédé selon l'une quelconque des revendications 1 à 8 ou dispositif selon la revendication 10 ou 11, dans lequel chaque couche ferromagnétique est réalisée dans un matériau magnétostrictif qui présente un coefficient $\lambda_s$ de magnétostriction dont la valeur absolue est supérieure à 50 ppm.

13. Procédé selon l'une quelconque des revendications 1 à 8 ou dispositif selon la revendication 10 ou 11, dans lequel la couche précontrainte exerce une contrainte uniaxiale σ dans la direction longitudinale de chaque bloc magnétique telle que $\lambda_s\sigma$ est supérieur ou égal à 10 000 ppm.MPa.

**Patentansprüche**

1. Verfahren zur Herstellung einer Vorrichtung, umfassend mehrere magnetische Einheiten, die in verschiedenen Richtungen magnetisiert sind, wobei dieses Verfahren umfasst:

   a) Bilden (2, 4) einer ersten und einer zweiten länglichen und getrennten magnetischen Einheit auf einem Substrat, das sich im Wesentlichen in einer Ebene erstreckt, die als "Ebene des Substrats" bezeichnet wird, wobei sich diese Einheiten im Wesentlichen jeweils entlang Längsrichtungen X und Y erstrecken, die dazwischen einen Winkel α von nicht Null bilden, wobei die Länge L jeder Einheit entlang ihrer Längsrichtung mindestens größer ist als das Zwanzigfache ihrer Breite W in einer Querrichtung rechtwinklig zur Längsrichtung und parallel zur Ebene des Substrats, wobei jede Einheit aus einem Stapel mehrerer ferromagnetischer und antiferromagnetischer Schichten gebildet ist, die abwechselnd direkt aufeinander angeordnet sind, wobei jede ferromagnetische Schicht aus einem magnetostriktiven Material besteht, das einen Magnetostriktionskoeffizienten $\lambda_s$ aufweist, dessen Absolutwert größer ist als 20 ppm,

   b) Wärmebehandeln (8) der ersten und zweiten Einheit bei einer Temperatur über der Ordnungstemperatur oder über der Blockierungstemperatur oder über der Néel-Temperatur jeder antiferromagnetischen Schicht jeder Einheit,

   **dadurch gekennzeichnet, dass** das Verfahren umfasst:

   c) Abscheiden (6) einer vorgespannten Schicht, die eine uniaxiale Spannung σ in der Längsrichtung jeder magnetischen Einheit ausübt, so dass $\lambda_s\sigma$ positiv und größer oder gleich 1000 ppm.MPa ist, um die Ausrichtung der Magnetisierungsrichtung jeder ferromagnetischen Schicht in der Längsrichtung zu verbessern.

2. Verfahren nach Anspruch 1, wobei das Verfahren umfasst:

   d) während des Wärmebehandlungsschritts, Anlegen (10) eines ersten Magnetfelds in einer Richtung, die einen Winkel θ von nicht Null mit den Längsrichtungen X und Y bildet, wobei die Intensität dieses ersten Magnetfelds:

   - größer ist als ein Sättigungsfeld $H_{W1}$ längs der schwierigsten Magnetisierungsachse dieser ersten Einheit, und
   - größer ist als ein Sättigungsfeld $H_{W2}$ längs der schwierigsten Magnetisierungsachse dieser zweiten Einheit.

3. Verfahren nach Anspruch 2, wobei das Verfahren umfasst:

   e) nach dem Schritt d), Anlegen (12) eines zweiten Magnetfelds, dessen Intensität derart ist, dass:

   - das Modul der orthogonalen Projektion des zweiten Magnetfelds entlang der Längsrichtung der ersten Einheit größer ist als ein Sättigungsfeld $H_{L1}$ längs der leichtesten Magnetisierungsachse dieser ersten Einheit,
   - das Modul der orthogonalen Projektion des zweiten Magnetfelds entlang der Querrichtung der ersten Einheit kleiner ist als das Sättigungsfeld $H_{W1}$ längs der schwierigsten Magnetisierungsachse dieser ersten Einheit,
   - das Modul der orthogonalen Projektion des zweiten Magnetfelds entlang der Längsrichtung der zweiten Einheit größer ist als ein Sättigungsfeld $H_{L2}$ längs der leichtesten Magnetisierungsachse dieser zweiten Einheit, und
   - das Modul der orthogonalen Projektion des zweiten Magnetfelds entlang der Querrichtung der zweiten Einheit kleiner ist als ein Sättigungsfeld $H_{W2}$ längs der schwierigsten Magnetisierungsachse dieser zweiten Einheit.

4. Verfahren nach Anspruch 3, wobei Schritt e) durchgeführt wird, während gleichzeitig jede Einheit unter die Ordnungstemperatur oder unter die Blockierungstemperatur oder unter die Néel-Temperatur jeder antiferromagnetischen Schicht abkühlen gelassen wird.

**5.** Verfahren nach einem der Ansprüche 3 bis 4, wobei der Winkel zwischen den Längsrichtungen der ersten und zweiten Einheit gleich 90° ist, und das Magnetfeld, das in Schritt e) angelegt wird, einen Winkel von 45° mit der Längsrichtung der ersten Einheit bildet.

**6.** Verfahren nach einem der Ansprüche 3 bis 5, wobei Schritt c) nach dem Ende von Schritt e) durchgeführt wird.

**7.** Verfahren nach einem der Ansprüche 1 bis 5, wobei Schritt c) vor Schritt b) oder gleichzeitig mit Schritt b) durchgeführt wird.

**8.** Verfahren nach Anspruch 7, wobei die Schritte b) und c) gleichzeitig derart durchgeführt werden, dass Schritt c) bei einer Temperatur über der Ordnungstemperatur oder über der Blockierungstemperatur oder über der Néel-Temperatur jeder antiferromagnetischen Schicht durchgeführt wird.

**9.** Verfahren zur Herstellung eines Magnetsensors, **dadurch gekennzeichnet, dass** dieses die Durchführung eines Verfahrens nach einem der vorhergehenden Ansprüche umfasst, um mindestens zwei magnetische Einheiten mit verschiedenen Magnetisierungseinfangrichtungen in derselben Ebene herzustellen.

**10.** Vorrichtung, umfassend:

- ein Substrat (101), das sich im Wesentlichen parallel zu einer Ebene erstreckt, die als "Ebene des Substrats" bezeichnet wird,
- mindestens zwei magnetische Einheiten (111-113), die in von der Ebene des Substrats verschiedenen Richtungen magnetisiert sind, wobei die Länge jeder dieser magnetischen Einheiten in ihrer Längsrichtung mindestens zwanzig Mal größer ist als ihre Breite in einer Querrichtung rechtwinklig zur Längsrichtung und parallel zur Ebene des Substrats, wobei jede Einheit aus einem Stapel mehrerer ferromagnetischer und antiferromagnetischer Schichten gebildet ist, die abwechselnd direkt aufeinander abgeschieden sind,

**dadurch gekennzeichnet, dass**:

- jede ferromagnetische Schicht (105) aus einem magnetostriktiven Material besteht, das einen Magnetostriktionskoeffizienten $\lambda_s$ aufweist, dessen Absolutwert größer ist als 20 ppm, und
- die Vorrichtung eine vorgespannte Schicht (116) umfasst, die eine uniaxiale Spannung $\sigma$ auf jede magnetische Einheit ausübt, so dass $\lambda_s\sigma$ positiv und größer oder gleich 1000 ppm.MPa ist, um die Ausrichtung der Magnetisierungsrichtung jeder ferromagnetischen Schicht in der Längsrichtung zu verbessern.

**11.** Vorrichtung nach Anspruch 10, wobei die vorgespannte Schicht aus Oxid oder aus Nitrid oder aus Metall besteht.

**12.** Verfahren nach einem der Ansprüche 1 bis 8 oder Vorrichtung nach Anspruch 10 oder 11, wobei jede ferromagnetische Schicht aus einem magnetostriktiven Material besteht, das einen Magnetostriktionskoeffizienten $\lambda_s$ aufweist, dessen Absolutwert größer ist als 50 ppm.

**13.** Verfahren nach einem der Ansprüche 1 bis 8 oder Vorrichtung nach Anspruch 10 oder 11, wobei jede vorgespannte Schicht eine uniaxiale Spannung $\sigma$ in der Längsrichtung jeder magnetischen Einheit aufweist, so dass $\lambda_s\sigma$ größer oder gleich 10 000 ppm.MPa ist.

**Claims**

**1.** Method for producing a device comprising several magnetic blocks magnetized in different directions, this method comprising:

a) the formation (2, 4) of a first and a second slender and separate magnetic blocks on a substrate extending essentially in a plane called "plane of the substrate", these blocks extending essentially along, respectively, longitudinal directions X and Y producing between them a non-zero angle $\alpha$, the length L of each block along its longitudinal direction being at least greater than twenty times its width W in a transverse direction at right angles to the longitudinal direction and parallel to the plane of the substrate, each block being formed by a stack of several ferromagnetic and antiferromagnetic layers arranged alternately directly one on top of the other, each ferromagnetic layer being produced in a magnetostrictive material which exhibits a magnetostriction coefficient

$\lambda_s$ whose absolute value is greater than 20 ppm,
b) the annealing (8) of the first and second blocks at a temperature greater than the ordering temperature or than the blocking temperature or than the Néel temperature of each antiferromagnetic layer of each block,

**characterized in that** the method comprises:

c) the deposition (6) of a prestressing layer exerting a uniaxial stress $\sigma$ in the longitudinal direction of each magnetic block such that $\lambda_s\sigma$ is positive and greater than or equal to 1000 ppm.MPa so as to enhance the alignment of the direction of magnetization of each ferromagnetic layer in the longitudinal direction.

2. Method according to Claim 1, in which the method comprises:

d) during the annealing step, the application (10) of a first magnetic field in a direction producing a non-zero angle $\theta$ with the longitudinal directions X and Y, the intensity of this first magnetic field being:

• greater than a saturation field $H_{W1}$ along the hardest axis of magnetization of this first block, and
• greater than a saturation field $H_{W2}$ along the hardest axis of magnetization of this second block.

3. Method according to Claim 2, in which the method comprises:

e) after the step d), the application (12) of a second magnetic field whose intensity is such that:

• the modulus of the orthogonal projection of the second magnetic field along the longitudinal direction of the first block is greater than a saturation field $H_{L1}$ along the easiest axis of magnetization of this first block,
• the modulus of the orthogonal projection of the second magnetic field along the transverse direction of the first block is less than the saturation field $H_{W1}$ along the hardest axis of magnetization of this first block,
• the modulus of the orthogonal projection of the second magnetic field along the longitudinal direction of the second block is greater than a saturation field $H_{L2}$ along the easiest axis of magnetization of this second block, and
• the modulus of the orthogonal projection of the second magnetic field along the transverse direction of the second block is less than the saturation field $H_{W2}$ along the hardest axis of magnetization of this second block.

4. Method according to Claim 3, in which the step e) is performed while allowing each block to cool below the ordering temperature or the blocking temperature or the Néel temperature of each antiferromagnetic layer.

5. Method according to either one of Claims 3 or 4, in which the angle between the longitudinal directions of the first and second blocks is equal to 90° and the magnetic field applied in the step e) forms an angle of 45° with the longitudinal direction of the first block.

6. Method according to any one of Claims 3 to 5, in which the step c) is performed after the end of the step e).

7. Method according to any one of Claims 1 to 5, in which the step c) is performed before the step b) or at the same time as the step b).

8. Method according to Claim 7, in which the steps b) and c) are performed at the same time so that the step c) is performed at a temperature higher than the ordering temperature or the blocking temperature or the Néel temperature of each antiferromagnetic layer.

9. Method for fabricating a magnetic sensor, **characterized in that** it comprises the implementation of a method according to any one of the preceding claims to produce at least two magnetic blocks having different magnetization trapping directions in the same plane.

10. Device comprising:

- a substrate (101) extending essentially parallel to a plane called "plane of the substrate",
- at least two magnetic blocks (111-113) magnetized in different directions parallel to the plane of the substrate, the length of each of these magnetic blocks in its longitudinal direction being at least twenty times greater than its width in a transverse direction at right angles to the longitudinal direction and parallel to the plane of the substrate, each block being formed by a stack of several ferromagnetic and antiferromagnetic layers deposited alternately directly one on top of the other,

**characterized in that**:

- each ferromagnetic layer (105) is produced in a magnetostrictive material which exhibits a magnetostriction coefficient $\lambda_s$ whose absolute value is greater than 20 ppm, and
- the device comprises a prestressing layer (116) exerting a uniaxial stress $\sigma$ on each magnetic block such that $\lambda_s\sigma$ is positive and greater than or equal to 1000 ppm.MPa so as to enhance the alignment of the direction of magnetization of each ferromagnetic layer in the longitudinal direction.

11. Device according to Claim 10, in which the prestressing layer is made of oxide or of nitride or of metal.

12. Method according to any one of Claims 1 to 8 or device according to Claim 10 or 11, in which each ferromagnetic layer is produced in a magnetostrictive material which exhibits a magnetostriction coefficient $\lambda_s$ whose absolute value is greater than 50 ppm.

13. Method according to any one of Claims 1 to 8 or device according to Claim 10 or 11, in which the prestressing layer exerts a uniaxial stress $\sigma$ in the longitudinal direction of each magnetic block such that $\lambda_s\sigma$ is greater than or equal to 10 000 ppm.MPa.

Fig. 1

Fig. 2

Fig. 3

Fig. 4

Fig. 5

Fig. 6

Fig. 7

Fig. 8

Fig. 9

Fig. 10

Fig. 11

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- EP 2341358 A

- WO 2011001293 A

**Littérature non-brevet citée dans la description**

- A novel microfabricated high précision vector magnetometer. **ETTELT D et al.** 2011 IEEE Sensors. IEEE, 28 Octobre 2011, 2010-2013

- **B. ETTELT et al.** A new low consumption 3D compass using integrated magnets and piezoresistive nano-gauges. *Transducers 2011 Conférence*